# EUROPEAN PATENT APPLICATION

(11) **EP 4 679 483 A2**
(43) Date of publication of application: **14.01.2026**
(21) Application number: 25178621.6
(22) Date of filing: 23.05.2025
(51) Int. Cl.: H01J 37/20

(54) **OBSERVATION INSTRUMENT AND CONTROL METHOD FOR SAMPLE STAGE**

(30) Priority: 08.07.2024 JP 2024109642
(71) Applicant: Jeol Ltd., Akishima-shi, Tokyo 196-8558 (JP)
(72) Inventor: SHIGEYAMA, Wataru, Tokyo, 196-8558 (JP); MIZUNO, Noriaki, Tokyo, 196-8558 (JP)
(74) Representative: Boult Wade Tennant LLP

(57) **Abstract**

There is provided an observation instrument capable of reducing drift of a sample. The inventive observation instrument (100) is used for observation of the sample (S) and includes a sample stage (10) and a controller (40) for controlling the sample stage (10). The sample stage (10) has a sample support base (16) on which the sample (S) is placed, a first drive mechanism (13) for displacing the sample support base (16) relative to a first axis, and a second drive mechanism (14) for displacing the sample support base (16) relative to a second axis different from the first axis. If the first drive mechanism (13) is caused to perform a first operation for displacing the sample support base (16) relative to the first axis, the controller (40) causes the second drive mechanism (14) to perform a second operation for reducing such drift of the sample support base (16) relative to the second axis that is concomitant with the first operation.

## Description

### BACKGROUND OF THE INVENTION

### 1. Field of the Invention

The present invention relates to an observation instrument and also to a control method for a sample stage used therein.

### 2. Description of the Related Art

When a scanning electron microscope, a focused ion beam (FIB) system, an optical microscope, or the like is used, microscopic regions of a sample can be observed. In order to perform such an observation, it is necessary to maintain the sample fixed after it is moved to a target position. However, a sample stage used to place the sample in position suffers from drift due to (i) flexure of mechanical parts making up the sample stage, (ii) backlash between mechanical parts, and/or (iii) stress resulting from the viscous resistance of a lubricant used on the mechanical parts.

For example, Patent document 1 discloses a technique regarding a stage drive device equipped with a motor for stopping a sample stage. When the movement of the stage comes to a stop, drift of the stage is reduced by reversing the direction of rotation of the motor immediately prior to the stoppage of the motor.

### Citation List

### Patent Documents

Patent document 1: JP-A-2008-16367

In the technique of Patent document 1, the direction of movement of the sample stage is identical to the direction of drift. However, drift may arise in directions different from the direction of movement of the sample stage.

### SUMMARY OF THE INVENTION

One aspect of the observation instrument associated with the present invention is used to observe a sample and comprises:
a sample stage having a sample support base on which the sample is placed, a first drive mechanism for displacing the sample support base relative to a first axis, and a second drive mechanism for displacing the sample support base relative to a second axis different from the first axis; and
a controller for controlling the sample stage.

When the first drive mechanism is caused to perform a first operation for displacing the sample support base relative to the first axis, the controller causes the second drive mechanism to perform a second operation for reducing drift of the sample support base relative to the second axis owing to the first operation.

With this observation instrument, it is possible to reduce drift of the sample support base relative to the second axis due to the first operation for displacing the sample support base relative to the first axis.

One aspect of the method of controlling a sample stage in accordance with the present invention is adapted to control the sample stage for use in an observation instrument, the sample stage comprising: a sample support base on which a sample is placed; a first drive mechanism for displacing the sample support base relative to a first axis; and a second drive mechanism for displacing the sample support base relative to a second axis different from the first axis. The method comprises the steps of: causing the first drive mechanism to perform a first operation for displacing the sample support base relative to the first axis; and, if the first drive mechanism has been caused to perform the first operation for displacing the sample support base relative to the first axis, causing the second drive mechanism to perform a second operation for reducing drift of the sample stage relative to the second axis owing to the first operation.

In this control method for the sample stage, drift of the sample support base relative to the second axis due to the first operation for displacing the sample support base relative to the first axis can be reduced.

### BRIEF DESCRIPTION OF THE DRAWINGS

FIG. 1 is a schematic view showing one example of configuration of an electron microscope associated with a first embodiment of the present invention.
FIG. 2 is a block diagram of one example of configuration of a controller.
FIGS. 3-5 are schematic front elevations illustrating operations of a sample stage.
FIG. 6 is a flowchart illustrating one example of processing sequence performed by the controller for tilting.
FIG. 7 is a schematic view showing one example of configuration of an electron microscope associated with a second embodiment.
FIG. 8 is a schematic front elevation illustrating the operation of the electron microscope.
FIG. 9 is a flowchart illustrating one example of processing sequence performed by a controller for tilting.
FIG. 10 is a schematic view showing one example of configuration of an electron microscope associated with a third embodiment.
FIG. 11 is a schematic front elevation illustrating the operation of a sample stage.
FIG. 12 is a flowchart illustrating one example of processing sequence performed by a controller for tilting.
FIG. 13 is a schematic view showing one example of configuration of an electron microscope associated with a fourth embodiment.
FIG. 14 is a perspective view illustrating the operation of the electron microscope.
FIG. 15 is a flowchart illustrating one example of processing sequence performed by a controller for tilting.
FIG. 16 is a schematic view showing one example of configuration of an electron microscope associated with a fifth embodiment.
FIGS. 17 and 18 are schematic views illustrating operations of a sample stage.
FIG. 19 is a flowchart illustrating one example of processing sequence performed by a controller to make a movement along an X-axis.

### DETAILED DESCRIPTION OF THE INVENTION

The preferred embodiments of the present invention are hereinafter described in detail with reference to the drawings. It is to be understood that the embodiments provided below do not unduly restrict the scope and content of the present invention delineated by the appended claims and that not all the configurations described below are essential constituent components of the invention.

In the following description, an electron microscope for observing a sample using an electron beam is taken as one example of the observation instrument associated with the present invention. The observation instrument associated with the present invention is not restricted to scanning electron microscopes but may be any observation instrument for observing samples using electrons, ions, radiation, or light (such as laser light).

### 1. First Embodiment

### 1.1. Electron Microscope

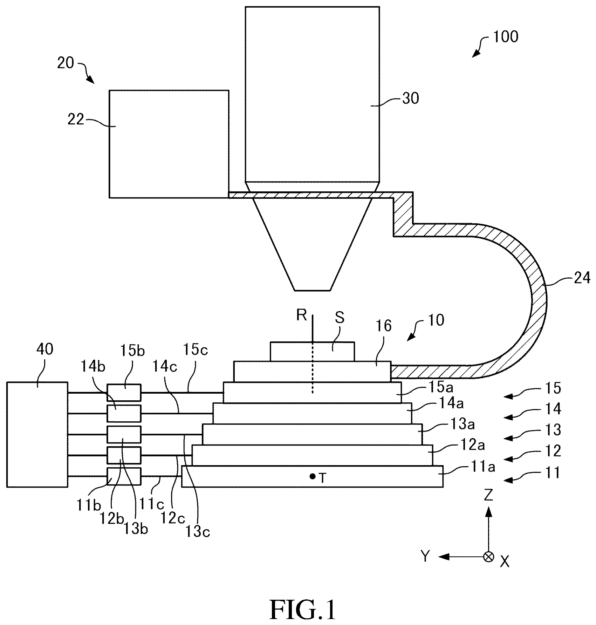

An electron microscope associated with a first embodiment is first described by referring to FIG. 1, which shows one example of configuration of the electron microscope, 100, associated with the first embodiment. In FIG. 1, there are shown X, Y, and Z axes as three mutually perpendicular axes. The X, Y, and Z axes constitute a system of coordinates representing the position of a sample support base 16 (described later) within the microscope 100.

The electron microscope 100 is used to observe a sample using electrons. The electron microscope 100 is a scanning electron microscope which focuses an electron beam into an electron probe, scans the sample S with the electron probe, and obtains a sample image. As shown in FIG. 1, the electron microscope 100 includes a sample stage 10, a stage cooling mechanism 20, an electron optical system 30, and a controller 40.

The sample stage 10 includes a tilt drive mechanism 11, a Z drive mechanism 12, an X drive mechanism 13, a Y drive mechanism 14, a rotary drive mechanism 15, and the above-described sample support base 16. The sample stage 10 is a five-axis stage mechanism capable of displacing itself relative to five axes and thus the sample stage 10 can perform five operations: two kinds of horizontal movement (X, Y), vertical movement (Z), tilting (T), and rotation (R).

The tilt drive mechanism 11 displaces or tilts the sample support base 16 relative to or about an axis T parallel to the X axis. The tilt drive mechanism 11 includes a tilt stage 11a, a tilting force generator 11b, and a tilting force transfer member 11c.

The tilt stage 11a tilts about the axis of tilt T which passes through the center of the tilt stage 11a. The tilt stage 11a is tilted by the force generated by the tilting force generator 11b which is a source of the driving force. The tilting force generator 11b is an electric motor, for example. The tilting force transfer member 11c is made up of a plurality of mechanical parts including a shaft, joints, and gears. The tilting force transfer member 11c mechanically interconnects the tilting force generator 11b and the tilt stage 11a.

The Z drive mechanism 12 displaces or moves the sample support base 16 relative to or along the Z axis. That is, the Z drive mechanism 12 moves the sample support base 16 heightwise of the sample S. The Z drive mechanism 12 includes a Z stage 12a, a Z force generator 12b, and a Z force transfer member 12c.

The Z stage 12a is driven by a force generated by the Z force generator 12b and moves on the tilt stage 11a along the Z axis. The Z force generator 12b that is a source of the driving force is an electric motor, for example. The Z force transfer member 12c is made up of a plurality of mechanical parts including a shaft, joints, and gears. The Z force transfer member 12c mechanically interconnects the Z force generator 12b and the Z stage 12a.

The X drive mechanism 13 displaces or moves the sample support base 16 relative to or along the X axis, i.e., in a direction perpendicular to the heightwise direction of the sample S. The X drive mechanism 13 includes an X stage 13a, an X force generator 13b, and an X force transfer member 13c.

The X stage 13a is driven by a force generated by the X force generator 13b and moves on the Z stage 12a along the X axis. The X force generator 13b that is a source of the driving force is an electric motor, for example. The X force transfer member 13c is made up of a plurality of mechanical parts including a shaft, joints, and gears. The X force transfer member 13c mechanically interconnects the X force generator 13b and the X stage 13a.

The Y drive mechanism 14 displaces or moves the sample support base 16 relative to or along the Y axis, i.e., in a direction perpendicular to the heightwise direction of the sample S. The Y drive mechanism 14 includes a Y stage 14a, a Y force generator 14b, and a Y force transfer member 14c.

The Y stage 14a is driven by a force generated by the Y force generator 14b and moves on the X stage 13a along the Y axis. The Y force generator 14b that is a source of the driving force is an electric motor, for example. The Y force transfer member 14c is made up of a plurality of mechanical parts including a shaft, joints, and gears and mechanically interconnects the Y force generator 14b and the Y stage 14a.

The rotary drive mechanism 15 displaces or rotates the sample support base 16 relative to or about an axis R parallel to the Z axis. The rotary drive mechanism 15 includes a rotary stage 15a, a rotary force generator 15b, and a rotary force transfer member 15c.

The rotary stage 15a is driven by a force generated by the rotary force generator 15b and rotates on the Y stage 14a about the axis of rotation R that passes through the center of the rotary stage 15a. The rotary force generator 15b that is a source of the driving force is an electric motor, for example, and is made up of a plurality of mechanical parts including a shaft, joints, and gears. The rotary force transfer member 15c mechanically interconnects the rotary force generator 15b and the rotary stage 15a.

The sample support base 16 in which the sample S is positioned is placed on the rotary stage 15a. The sample S on the sample support base 16 is irradiated with an electron beam from the electron optical system 30.

In the example shown in FIG. 1, the Z stage 12a is placed on the tilt stage 11a. The X stage 13a is placed on the Z stage 12a. The Y stage 14a is placed on the X stage 13a. The rotary stage 15a is placed on the Y stage 14a. The sample support base 16 is placed on the rotary stage 15a. In this way, the tilt stage 11a, the Z stage 12a, the X stage 13a, the Y stage 14a, the rotary stage 15a, and the sample support base 16 are placed in this order along the Z axis. The arrangement of the stages along the Z axis is not restricted to the example of FIG. 1.

The stage cooling mechanism 20 cools the sample stage 10, whereby the sample S can be cooled. As a result, the morphology of the sample S under low temperatures can be observed. Furthermore, cooling of the sample S can lead to a decrease in the damage to the sample S due to an electron beam. The stage cooling mechanism 20 includes a refrigerant tank 22 and a heat transfer member 24.

The refrigerant tank 22 is filled with liquid nitrogen, for example. The heat transfer member 24 thermally interconnects the refrigerant tank 22 and the sample support base 16. The heat transfer member 24 is made of plain stitch fabric, for example. The material of the heat transfer member 24 may also be a metal plate, heat transfer wires, or the like. In addition, the heat transfer member 24 may be a gas tube for supplying cooling gas to the sample support base 16.

The electron optical system 30 is an optical system for directing an electron beam at the sample S and includes an electron gun, lenses, and scan coils. The electron optical system 30 operates to focus the electron beam into an electron probe and to scan the probe on the surface of the sample S. The electron microscope 100 is equipped with a detector (not shown) for detecting electrons emanating from the sample S in response to the irradiation of the sample S with the electron beam. The electron microscope 100 can obtain an SEM (scanning electron microscope) image by detecting the electrons emanating from the sample S by means of the detector while scanning the sample S with the electron probe via the electron optical system 30.

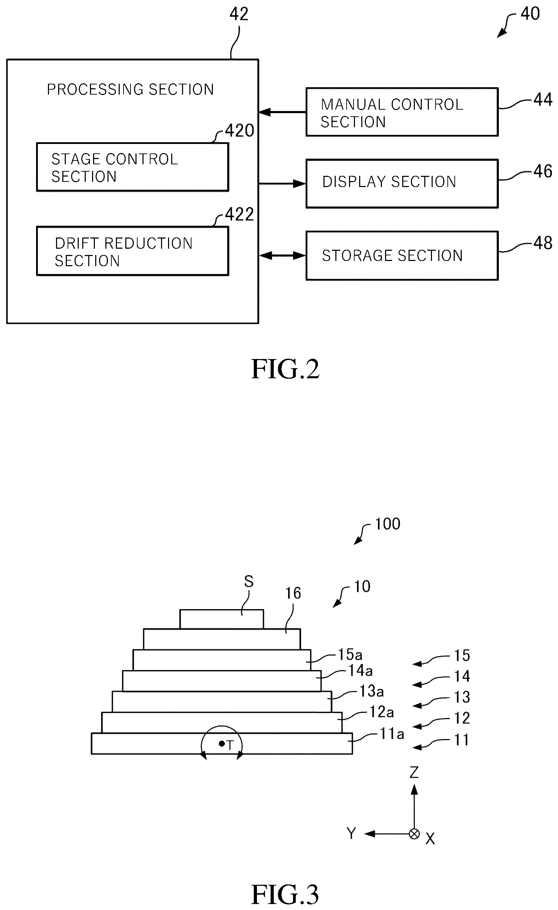

The controller 40 controls the sample stage 10. One example of the configuration of the controller 40 is shown in FIG. 2. The controller 40 includes a processing section 42, a manual control section 44, a display section 46, and a storage section 48 as shown.

The manual control section 44 permits a user to enter control information and outputs the entered control information to the processing section 42. The function of the manual control section 44 can be implemented by an input device such as a keyboard, a mouse, buttons, a touch panel, or a touch pad.

The display section 46 displays images created by the processing section 42. The function of the display section 46 can be realized by an LCD (liquid crystal display), a touch-sensitive display, or the like.

The storage section 48 stores programs, data, and other information permitting the processing section 42 to perform various computing operations and various control operations. Furthermore, the storage section 48 is used as a working area for the processing section 42, and is also used to temporarily store the results of calculations performed by the processing section 42 in accordance with various programs. The function of the storage section 48 can be implemented by a RAM (random access memory), a ROM (read only memory), a hard disk, or the like.

The functions of the processing section 42 can be implemented by causing various processors such as CPU (central processing unit), GPU (graphics processing unit), and DSP (digital signal processor) to carry out programs stored in the storage section 48. The processing section 42 includes a stage control section 420 and a drift reduction section 422.

The stage control section 420 controls the sample stage 10. Specifically, the stage control section 420 controls the tilt drive mechanism 11, the Z drive mechanism 12, the X drive mechanism 13, the Y drive mechanism 14, and the rotary drive mechanism 15.

The drift reduction section 422 performs processing for reducing the drift of the sample support base 16. When the tilt drive mechanism 11 is made to perform a tilting operation that is one example of a first operation in order to displace the sample support base 16 relative to the axis T, the drift reduction section 422 causes the Y drive mechanism 14 to perform a drift reducing operation that is one example of a second operation in order to reduce drift of the sample support base 16 relative to the Y axis due to the tilting operation.

### 1.2. Operation

An operation performed when the sample support base 16 is tilted in the electron microscope 100 is next described by referring to FIGS. 3-5 which illustrate the operation of the sample stage 10.

Referring to FIG. 3, the sample support base 16 is at its initial position whose coordinates are indicated by (X, Y, Z, R, T) = (x1, y1, z1, r1, t1) where X indicates the position of the sample support base 16 along the X axis, Y indicates the position of the sample support base 16 along the Y axis, Z indicates the position of the sample support base 16 along the Z axis, R indicates the rotational angle of the sample support base 16 relative to the axis of rotation R, and T indicates the angle of tilt of the sample support base 16 relative to the axis T. When the sample support base 16 is tilted about the axis T, the Y and Z axes rotate around the X axis.

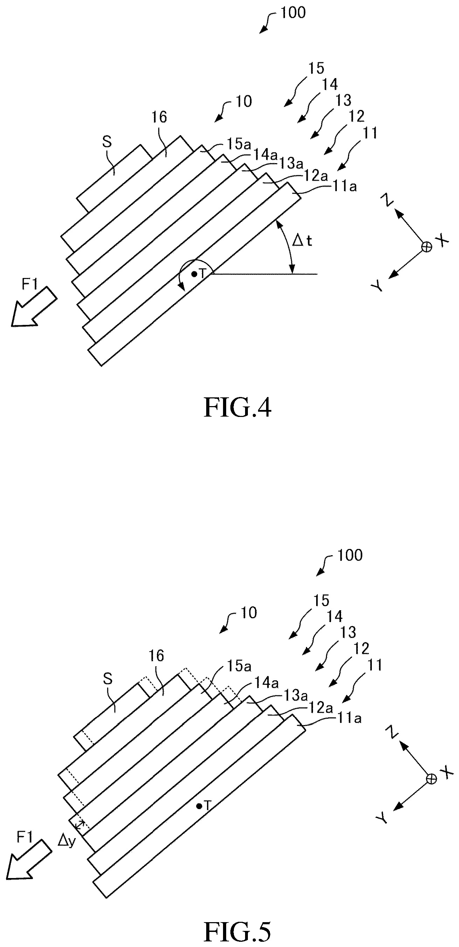

As shown in FIG. 4, the sample support base 16 is tilted counterclockwise by Δt. At this time, the tilt stage 11a is tilted counterclockwise by Δt. Consequently, the sample support base 16 moves from its initial position (x1, y1, z1, r1, t1) of FIG. 3 to a target position (x1, y1, z1, r1, t2) shown in FIG. 4.

If the sample support base 16 is tilted as shown in FIG. 4, a force F1 in the +Y direction is applied to the sample support base 16 by the heat transfer member 24 connected to the support base 16. This causes the sample support base 16 to drift in the +Y direction. The drift is attributable to flexure of the mechanical parts including the shaft, joints, and gears of the Y force transfer member 14c, to backlash between these mechanical parts, and to the stress produced by the viscous resistance of the lubricant used for the mechanical parts concomitantly with the application of the force F1 in the +Y direction to the sample support base 16.

Therefore, when a tilting operation for tilting the sample support base 16 is performed, a drift reducing operation for reducing the drift of the sample support base 16 relative to the Y axis caused by the tilting operation is carried out. The drift reducing operation is to move the sample support base 16 in the -Y direction after moving the sample support base 16 in the +Y direction in which the force F1 is applied to the sample support base 16. That is, the drift reducing operation is to swing the sample support base 16 in the -Y direction back to the target position after the sample support base 16 is swung in the +Y direction from the target position.

In particular, the Y stage 14a is first moved for a distance of Δy in the +Y direction. As a result, the sample support base 16 moves from the target position (x1, y1, z1, r1, t2) of FIG. 4 to a swing-back position (x1, yA, z1, r1, t2) shown in FIG. 5.

Then, the Y stage 14a is moved for a distance of Δy in the -Y direction. As a result, the sample support base 16 returns from the swing-back position (x1, yA, z1, r1, t2) of FIG. 5 to the target position (x1, y1, z1, r1, t2) of FIG. 4.

The amount of swing Δy for which the Y stage 14a is moved from the target position to the swing-back position is a preset value and constant irrespective of the tilt angle used for the tilting operation. Furthermore, the amount of swing back Δy for which the Y stage 14a is moved from the swing-back position to the target position is a preset value and constant irrespective of the tilt angle used for the tilting operation. In this example, the amount of swing and the amount of swing back have the same value of Δy but they may be different. The amount of swing and the amount of swing back are so set as to reduce the drift. The amount of swing and the amount of swing back can be determined experimentally or through computer simulation.

The drift reducing operation can mitigate the flexure of the mechanical parts of the Y force transfer member 14c and the stress caused by the viscous resistance of the lubricant used for the mechanical parts owing to the force F1 applied to the sample support base 16. Furthermore, the force F1 applied to the sample support base 16 by the heat transfer member 24 can be lessened by varying the posture of the heat transfer member 24 using the drift reducing operation. In addition, the surfaces of the teeth of one pair of gears can be brought into contact with each other by the Y force transfer member 14c, thus preventing the gears from moving due to the force F1 on the base 16 because the sample support base 16 is moved from the swing-back position in the direction opposite to that of the force F1 and brought to a stop by the drift reducing operation. This can reduce drift of the sample support base 16 due to backlash between mechanical parts. Consequently, drift of the sample support base 16 in the +Y direction due to tilting of the sample support base 16 can be reduced by the drift reducing operation.

In the foregoing example, the sample support base 16 is tilted counterclockwise by Δt. Similar operations can be performed where the sample support base 16 is tilted clockwise by Δt. That is, in this case, the drift reducing operation involves moving the Y stage 14a in the +Y direction after it is moved in the -Y direction in which a force is applied to the sample support base 16.

The direction of drift of the sample support base 16 when a tilting operation is performed has reproducibility and can be known in advance by experiments or computer simulation. Accordingly, a control program is previously stored in the storage section 48 to permit execution of the drift reducing operation when a tilting operation is performed.

### 1.3. Processing Sequence

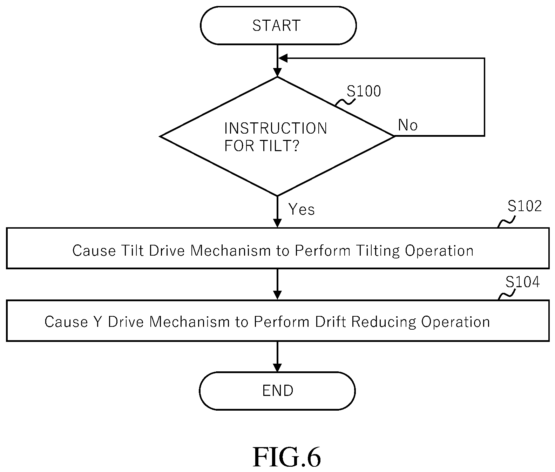

The processing sequence of the controller 40 when the sample support base 16 is tilted is next described by referring to FIG. 6 which is a flowchart of one example of a tilting operation of the controller 40.

The stage control section 420 makes a decision as to whether there is an instruction to tilt the sample support base 16 (step S100). The stage control section 420 determines that there is an instruction for tilting, for example, if the user enters an instruction to tilt the sample support base 16 via the manual control section 44. The instruction for tilting includes information about the angle and direction of the tilt. The direction of the tilt can be expressed, for example, in terms of the direction of rotation of the tilt stage 11a. In the example shown in FIG. 3, the direction is expressed as clockwise or counterclockwise.

If the decision at step S100 is affirmative (Yes), indicating that there is an instruction for tilting, the stage control section 420 causes the tilt drive mechanism 11 to perform a tilting operation for tilting the sample support base 16 (step S102). In particular, the stage control section 420 causes the tilting force generator 11b to tilt the tilt stage 11a by a designated angle in a designated direction.

Then, the drift reduction section 422 causes the Y drive mechanism 14 to perform a drift reducing operation (step S104). In particular, if the sample support base 16 is tilted counterclockwise during the tilting operation, the drift reduction section 422 causes the Y force generator 14b to move the Y stage 14a for a distance of Δy in the -Y direction after the Y stage 14a is moved for a distance of Δy in the +Y direction. If the sample support base 16 is tilted clockwise during the tilting operation, the drift reduction section 422 causes the Y force generator 14b to move the Y stage 14a for a distance of Δy in the +Y direction after the Y stage 14a is moved for a distance of Δy in the -Y direction. After causing the Y drive mechanism 14 to perform a drift reducing operation, the processing section 42 ends the processing sequence for tilting.

### 1.4. Advantageous Effects

The electron microscope 100 comprises the sample stage 10 and the controller 40 for controlling the sample stage 10 that includes the sample support base 16 on which the sample S is placed, the tilt drive mechanism 11 for displacing the sample support base 16 relative to the axis T, and the Y drive mechanism 14 for displacing the sample support base 16 relative to the Y axis different from the tilt axis T. If the tilt drive mechanism 11 is caused to perform a tilting operation for displacing the sample support base 16 relative to the axis T, the controller 40 causes the Y drive mechanism 14 to perform a drift reducing operation for reducing drift of the sample support base 16 relative to the Y axis concomitant with the tilting operation. Therefore, in the electron microscope 100, drift of the sample support base 16 along the Y axis due to tilting of the sample support base 16 relative to the axis of tilt T can be reduced.

Specifically, the tilt drive mechanism 11 tilts the sample support base 16 about the axis of tilt T. Also, the Y drive mechanism 14 moves the sample support base 16 along the Y axis. The tilting operation is to cause the tilt drive mechanism 11 to tilt the sample support base 16 about the axis of tilt T. The drift reducing operation is to cause the Y drive mechanism 14 to move the sample support base 16 in the second direction opposite to the first direction after the sample support base 16 is moved along the Y axis in the first direction. Therefore, in the electron microscope 100, drift of the sample support base 16 along the Y axis due to tilting of the sample support base 16 about the axis of tilt T can be reduced.

The control method for the sample stage 10 in the electron microscope 100 involves the step of performing a tilting operation, i.e., causing the tilt drive mechanism 11 to tilt the sample support base 16 relative to the axis T, and the step of performing a drift reducing operation for reducing drift of the sample support base 16 relative to the Y axis due to the tilting operation if the tilting operation of the sample support base 16 relative to the axis T has been performed by the tilt drive mechanism 11. Consequently, drift of the sample support base 16 along the Y axis due to tilting of the sample support base 16 about the axis of tilt T can be reduced.

### 1.5. Modifications

### 1.5.1. First Modification

In the above-described first embodiment, the controller 40 causes the Y drive mechanism 14 to perform a drift reducing operation when the tilt drive mechanism 11 has been caused to perform a tilting operation for tilting the sample support base 16. Alternatively, the controller 40 may cause the Y drive mechanism 14 to perform a drift reducing operation when the tilt drive mechanism 11 has been caused to perform a tilting operation for tilting the sample support base 16 by more than a given angle. That is, the controller 40 causes the tilt drive mechanism 11 to perform a tilting operation consisting of tilting the sample support base 16 by Δt. If the angle of tilt Δt is equal to or greater than a given value, the controller 40 causes the Y drive mechanism 14 to perform a drift reducing operation. If the tilting operation for tilting the sample support base 16 by Δt has been performed by the tilt drive mechanism 11, and if the angle of tilt Δt is less than the given value, the controller 40 does not cause the Y drive mechanism 14 to perform a drift reducing operation.

If the angle of tilt Δt assumed when the sample support base 16 is tilted is smaller, drift of the sample support base 16 along the Y axis may be negligibly small. In the first modification, if drift of the sample support base 16 is small, a drift reducing operation is not performed. When drift of the sample support base 16 is great, a drift reducing operation can be performed.

### 1.5.2. Second Modification

In the above-described first embodiment, when a tilting operation for rotating the sample support base 16 counterclockwise is performed, a drift reducing operation consisting of moving the sample support base 16 in the +Y direction for a distance of Δt and then moving the sample support base 16 for a distance of Δt in the -Y direction is performed. Where a tilting operation consisting of rotating the sample support base 16 clockwise is performed, a drift reducing operation consisting of moving the sample support base 16 for a distance of Δt in the -Y direction and then moving the sample support base 16 for a distance of Δt in the +Y direction is performed. In this way, in the drift reducing operation, the amount of swing for which the sample support base 16 is swung from the target position to the swing-back position and the amount of swing back for which the sample support base 16 is returned from the swing-back position to the target position are the same and equal to Δt.

In the drift reducing operation, even if the amount of swing and the amount of swing back are the same, the sample support base 16 may not return to the target position and deviate along the Y axis by the effects of backlash between mechanical parts making up the Y force transfer member 14c. The magnitude of the deviation of the sample support base 16 from the target position by the effects of backlash varies according to the combination of the direction of movement of the Y stage 14a immediately prior to the drift reducing operation and the direction of swing of the Y stage 14a in the drift reducing operation.

For example, for a case where the Y stage 14a is swung in the -Y direction by a drift reducing operation after the Y stage 14a is moved in the +Y direction and another case where the Y stage 14a is swung in the +Y direction by a drift reducing operation after the Y stage 14a is moved in the +Y direction, if the amount of swing and the amount of swing back are the same, the amount of deviation from the target position after the drift reducing operation is different. Similarly, for a case where the Y stage 14a is swung in the -Y direction by a drift reducing operation after the Y stage 14a is moved in the +Y direction and another case where the Y stage 14a is swung in the -Y direction by a drift reducing operation after the Y stage 14a is moved in the -Y direction, even if the amount of swing and the amount of swing back are the same, the amount of deviation from the target position after the drift reducing operation is different.

Accordingly, the drift reduction section 422 sets the amount of return used in a drift reducing operation according to the combination of the direction of movement of the Y stage 14a immediately prior to the drift reducing operation and the direction of swing of the Y stage 14a done in the drift reducing operation. The direction of movement (-Y or +Y direction) of the Y stage 14a immediately prior to a drift reducing operation and the direction of movement (-Y or +Y direction) of swing of the Y stage 14a in the drift reducing operation create four combinations. Therefore, amounts of return appropriate for the four combinations are previously stored in the storage section 48. The drift reduction section 422 reads an amount of return from the storage section 48 according to a combination and sets the amount of return.

For example, where the direction of movement of the Y stage 14a immediately prior to a drift reducing operation is the +Y direction and the direction of swing of the Y stage 14a in the drift reducing operation is the -Y direction, the drift reduction section 422 reads information about an amount of return Δy' corresponding to the combination from the storage section 48 and sets the amount of return to Δy'. The drift reduction section 422 moves the Y stage 14a in the - Y direction for a distance of Δy and then moves the stage 14a in the +Y direction for a distance of Δy'. Consequently, the deviation of the sample support base 16 from the target position due to the execution of the drift reducing operation can be reduced.

### 1.5.3. Thid Modification

In the electron microscope 100 associated with the above-described first embodiment, if the sample support base 16 is tilted, the heat transfer member 24 connected to the sample support base 16 applies the force F1 along the Y axis. However, depending on the position at which the heat transfer member 24 is mounted, when the sample support base 16 is tilted, a force along the X axis may be applied to the sample support base 16. In this case, the drift reduction section 422 may cause the X drive mechanism 13 to perform a drift reducing operation. That is, when the sample support base 16 is tilted, the drift reduction section 422 causes the X drive mechanism 13 to move the X stage 13a in the direction in which a force is produced by tilting of the sample support base 16 and then causes the X drive mechanism 13 to perform a drift reducing operation to move the X stage 13a in the opposite direction.

Also, in the electron microscope 100, if a force along the X axis and a force along the Y axis are both applied to the sample support base 16 when it is tilted, the drift reduction section 422 may cause both X drive mechanism 13 and Y drive mechanism 14 to perform their drift reducing operations.

### 1.5.4. Fourth Modification

In the above first embodiment, connection of the heat transfer member 24 to the sample support base 16 results in the application of the force F1 to the sample support base 16, thus giving rise to drift. Mechanical members connected to the sample support base 16 and causing drift are not restricted to the heat transfer member 24. These connected members causing drift may be plates, tubes, and cables. Also, mechanical members causing drift may be members which control the physical states of the sample S such as electric potential, magnetic field, light, acoustics, and vibrations.

### 2. Second Embodiment

### 2.1. Electron Microscope

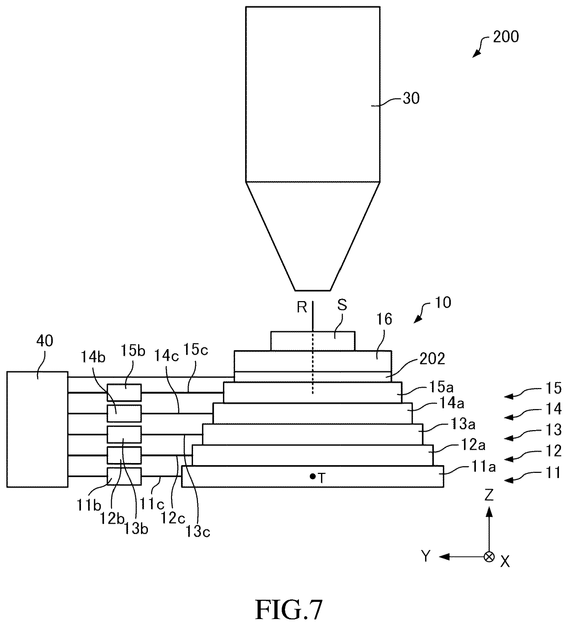

An electron microscope associated with a second embodiment is next described by referring to FIG. 7, which shows one example of configuration of the electron microscope, 200, associated with the second embodiment. Those members of the electron microscope 200 which are similar in function to their respective counterparts of the electron microscope 100 associated with the first embodiment are hereinafter indicated by the same reference numerals as in the foregoing figures and a detailed description thereof is omitted below.

As shown in FIG. 7, the electron microscope 200 includes a measuring device 202 for measuring the weight of the sample S placed on the sample support base 16. Examples of the measuring device 202 include strain gauge, pressure sensor, and a combination of a spring and displacement gauge for measuring the displacement of the spring. Note that the electron microscope 200 is not equipped with the stage cooling mechanism 20.

### 2.2. Operation

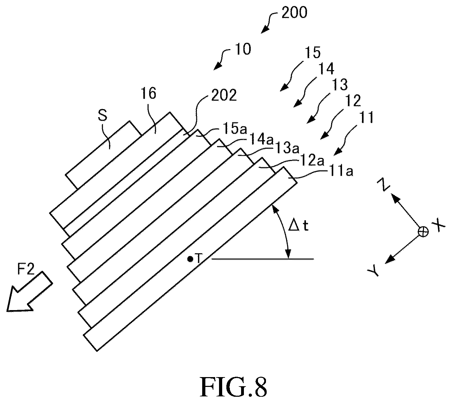

The operation of the electron microscope 200 when the sample support base 16 is tilted is next described by referring to FIG. 8, which illustrates the operation of the microscope 200. When the sample support base 16 is tilted as shown in FIG. 8, a force F2 in the +Y direction is applied to the sample support base 16 by the weights of the sample S and of the sample support base 16 itself. Where the weight of the sample S is great, the force F2 is great and causes the sample support base 16 to drift in the +Y direction.

Accordingly, in the electron microscope 200, if the weight of the sample S placed on the sample support base 16 is greater than a threshold value, a drift reducing operation is carried out. The threshold value is set, for example, to the upper limit of the weight of the sample S at which no drift occurs in the sample support base 16. The threshold value can be set to any arbitrary value.

### 2.3. Processing Sequence

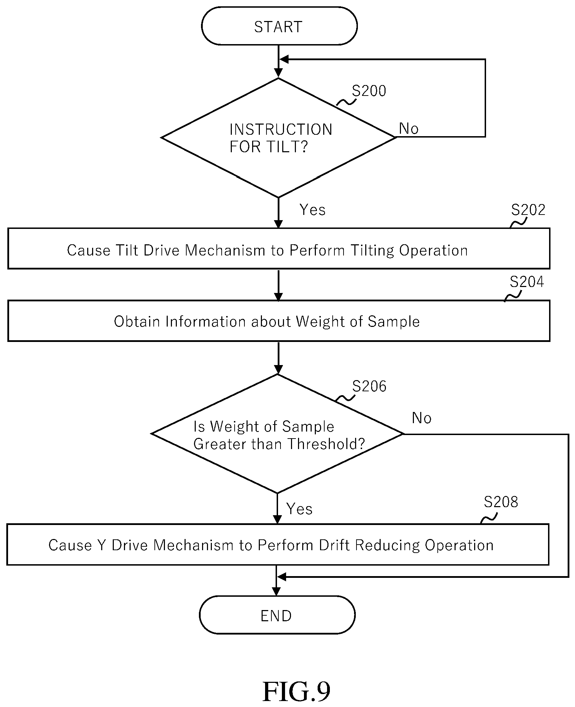

The processing sequence of the controller 40 when the sample support base 16 is tilted is next described. FIG. 9 is a flowchart illustrating one example of processing sequence of the controller 40 for tilting. In the following, only differences with the tilting operation illustrated in the above FIG. 6 are described; a description of similarities is omitted.

The stage control section 420 makes a decision as to whether there is an instruction to tilt the sample support base 16 (step S200).

If the stage control section 420 determines that there is an instruction for tilting, i.e., the decision at step S200 is affirmative (Yes), the stage control section 420 causes the tilt drive mechanism 11 to perform a tilting operation for tilting the sample support base 16 (step S202).

Then, the drift reduction section 422 obtains information about the weight of the sample S, the weight being measured by the measuring device 202 (step S204). The drift reduction section 422 compares the weight of the sample S against the threshold value and makes a decision as to whether the weight of the sample S is greater than the threshold value (step S206).

If the drift reduction section 422 determines that the weight of the sample S is greater than the threshold value, i.e., the decision at step S206 is affirmative (Yes), the drift reduction section 422 causes the Y drive mechanism 14 to perform a drift reducing operation (step S208).

The processing section 42 ends the processing sequence for tilting either after the Y drive mechanism 14 has been caused to carry out the drift reducing operation or if it has been determined that the weight of the sample S is less than the threshold value (i.e., decision at step S206 is negative (No)).

### 2.4. Advantageous Effects

The electron microscope 200 includes the measuring device 202 for measuring the weight of the sample S placed on the sample support base 16. If the weight of the sample S measured by the measuring device 202 is greater than the threshold value, the controller 40 causes the Y drive mechanism 14 to perform a drift reducing operation. Therefore, in the electron microscope 200, drift of the sample support base 16 along the Y axis due to tilting of the sample support base 16 can be reduced.

### 3. Third Embodiment

### 3.1. Electron Microscope

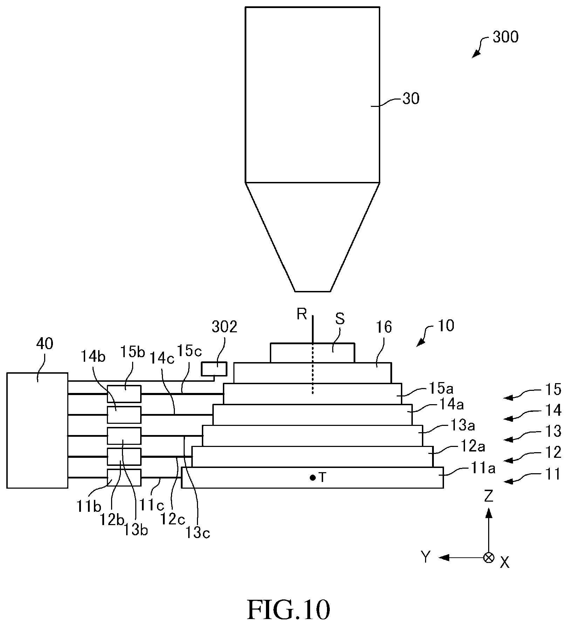

An electron microscope associated with a third embodiment is next described by referring to FIG. 10, which shows one example of configuration of the electron microscope, 300, associated with the third embodiment. Those members of the electron microscope 300 which are similar in function to their respective counterparts of the electron microscope 100 associated with the first embodiment are hereinafter indicated by the same reference numerals as in the foregoing figures and a detailed description thereof is omitted.

In the electron microscope 300, various types of sample support base 16 can be used in the sample stage 10. Therefore, the electron microscope 300 includes, as shown in FIG. 10, a bar code reader 302 for reading a one-dimensional or two-dimensional bar code attached to the sample support base 16, the code being used for identifying the type of the sample support base 16.

The bar code reader 302 is a camera capable of reading one and two-dimensional bar codes, for example. The reader 302 reads a one or two-dimensional bar code, obtains information about the type of the sample support base 16, and sends the information about the type of the base 16 to the controller 40. Note that the electron microscope 300 is not equipped with the stage cooling mechanism 20.

### 3.2. Operation

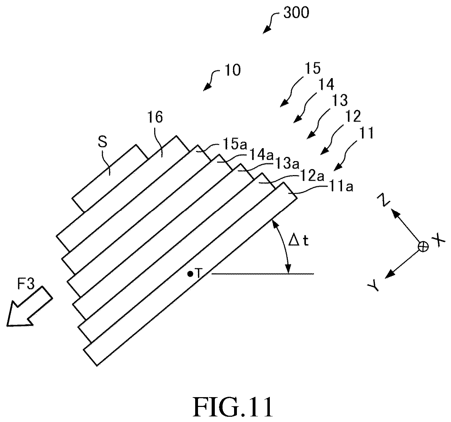

The operation of the electron microscope 300 when the sample support base 16 is tilted is next described by referring to FIG. 11, which illustrates the operation of the sample stage 10. When the sample support base 16 is tilted as shown in FIG. 11, a force F3 in the +Y direction is applied to the sample support base 16 by the weights of the sample S and of the sample support base 16. Where the weight of the sample support base 16 is large, the force F3 is large and drift in the +Y direction occurs in the sample support base 16.

Accordingly, the electron microscope 300 makes a decision as to whether or not a drift reducing operation is to be performed according to the type of the sample support base 16. A list of types of the sample support base 16 which will drift when tilted is previously stored in the storage section 48.

### 3.3. Processing Sequence

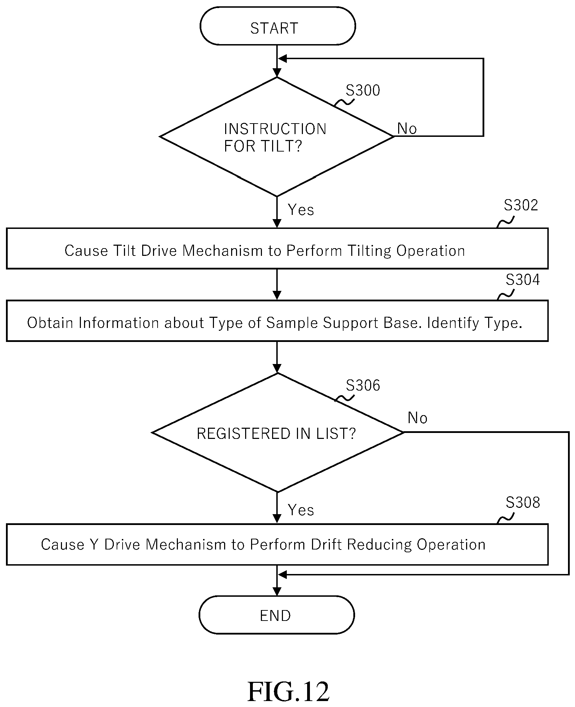

The processing sequence of the controller 40 when the sample support base 16 is tilted is next described. FIG. 12 is a flowchart illustrating one example of processing sequence of the controller 40 for tilting. Only the differences with the above-described processing sequence for tilting as illustrated in FIG. 6 are hereinafter described; a description of similarities is omitted below.

The stage control section 420 makes a decision as to whether there is an instruction to tilt the sample support base 16 (step S300).

If the decision at step S300 is affirmative (Yes), indicating that there an instruction for tilting, the stage control section 420 causes the tilt drive mechanism 11 to perform a tilting operation for tilting the sample support base 16 (step S302).

Then, the drift reduction section 422 obtains information about the type of the sample support base 16 now in use from the bar code reader 302 and identifies the type (step S304). The drift reduction section 422 makes a decision as to whether or not a drift reducing operation is to be performed by the Y drive mechanism 14 according to the identified type of the sample support base 16. More specifically, the drift reduction section 422 makes a decision based on the information about the type of the sample support base 16 obtained at step S304 as to whether or not the type is recorded in the list of types stored in the storage section 48 (step S306).

If the decision at step S306 is Yes, indicating that the type is recorded in the list, the drift reduction section 422 causes the Y drive mechanism 14 to perform a drift reducing operation (step S308).

The processing section 42 ends the processing sequence for tilting either after causing the Y drive mechanism 14 to perform a drift reducing operation or if the decision at step S306 is negative (No), indicating that the type is not recorded in the list.

### 3.4. Advantageous Effects

In the electron microscope 300, the controller 40 obtains information about the type of the sample support base 16, identifies the type, and makes a decision based on the identified type of the sample support base 16 as to whether a drift reducing operation is to be performed. Therefore, in the electron microscope 300, drift of the sample support base 16 along the Y axis due to tilting of the sample support base 16 can be reduced.

### 3.5. Modifications

In the above-described third embodiment, information about the type of the sample support base 16 is obtained by reading the one or two-dimensional bar code attached to the sample support base 16 with the bar code reader 302. Means for obtaining information about the type of the sample support base 16 is not restricted to this technique. For example, an SEM image of a one or two-dimensional bar code attached to the sample support base 16 is obtained, the one or two-dimensional bar code within the SEM image is read, and information about the type of the sample support base 16 may be derived. Furthermore, the user may enter information about the type of the sample support base 16 through the manual control section 44.

### 4. Fourth Embodiment

### 4.1. Electron Microscope

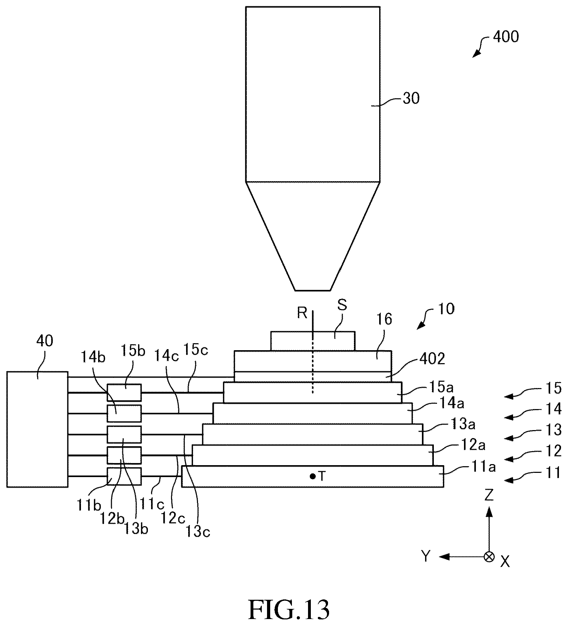

An electron microscope associated with a fourth embodiment is next described by referring to FIG. 13, which shows one example of configuration of the electron microscope, 400, associated with the fourth embodiment. Those members of the electron microscope 400 which are similar in function to their respective counterparts of the electron microscope 100 associated with the first embodiment are hereinafter indicated by the same reference numerals as in the foregoing figures and a detailed description thereof is omitted below.

As shown in FIG. 13, the electron microscope 400 includes a sensor 402 for detecting the position of the center of gravity of a unitary combination of the sample support base 16 and the sample S. Note that the electron microscope 400 is not equipped with the stage cooling mechanism 20.

### 4.2. Operation

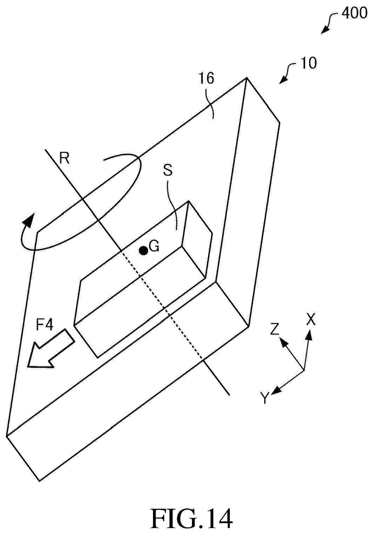

The operation of the electron microscope 400 when the sample support base 16 is tilted is next described by referring to FIG. 14, which illustrates the operation of the electron microscope 400. When the sample support base 16 is tilted counterclockwise by Δt about the axis R, the tilt stage 11a is tilted counterclockwise by Δt. As a result, the sample support base 16 moves from its initial position (x1, y1, z1, r1, t1) to the target position (x1, y1, z1, r1, t2).

When the sample S and the sample support base 16 are regarded as a unitary combination, if the position of the center of gravity G of the unitary combination does not lie on the axis of rotation R of the rotary stage 15a as shown in FIG. 14, and if the sample support base 16 is tilted, a force F4 in the -Y direction is applied to the sample support base 16. This results in rotational drift of the sample support base 16 about the axis R. In the example of FIG. 14, the sample support base 16 produces clockwise rotational drift about the axis R.

Therefore, where a tilting operation for tilting the sample support base 16 is performed, a drift reducing operation for reducing drift of the sample support base 16 relative to the axis R due to the tilting operation is performed. The drift reducing operation consists of rotating the rotary stage 15a in the direction of application of the force F4 to the sample support base 16, i.e., clockwise, and then rotating the rotary stage 15a in the reverse direction, i.e., counterclockwise.

In particular, the rotary stage 15a is first rotated clockwise by Δr. As a result, the sample support base 16 moves from the target position (x1, y1, z1, r1, t2) to the swing-back position (x1, y1, z1, rA, t2).

Then, the rotary stage 15a is rotated counterclockwise by Δr. As a result, the sample support base 16 returns from the swing-back position (x1, y1, z1, rA, t2) to the target position (x1, y1, z1, r1, t2). This drift reducing operation can reduce rotational drift of the sample support base 16 about the axis R.

In the foregoing example, the sample support base 16 is tilted counterclockwise by Δt. Similar operations can be performed where the sample support base 16 is tilted clockwise by Δt. That is, where the sample support base 16 is tilted clockwise by Δt, the rotary stage 15a is rotated counterclockwise followed by clockwise rotation.

The direction, or direction of rotation, of drift of the sample support base 16 is determined depending on the direction of tilt of the sample S and on the position of the center of gravity G of the unitary combination of the sample S and the sample support base 16. Therefore, in the electron microscope 400, the position of the center of gravity G is detected by the sensor 402. In the drift reducing operation, the direction of rotation of the rotary stage 15a is set depending on the direction of tilt of the sample S during a tilting operation and on the detected position of the center of gravity G.

### 4.3. Processing Sequence

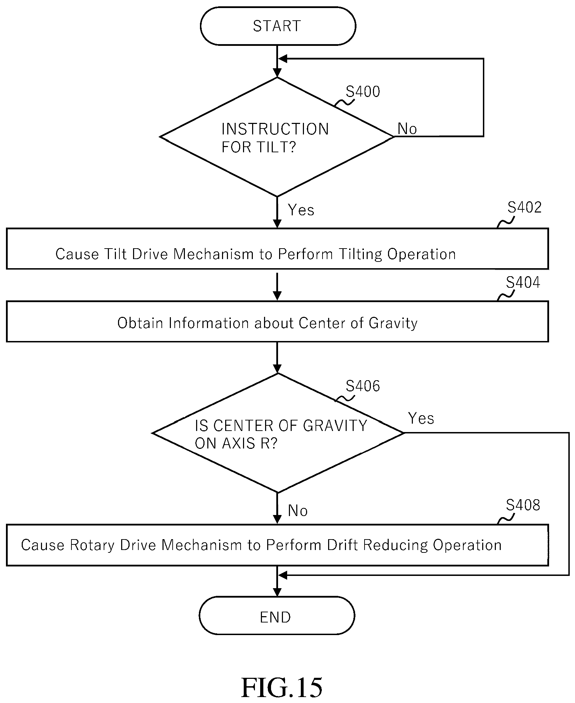

The processing sequence of the controller 40 when the sample support base 16 is tilted is next described. FIG. 15 is a flowchart illustrating one example of the processing sequence of the controller 40 for tilting. In the following, only differences with the above example of processing sequence for tilting as illustrated in FIG. 6 are described. A description of similarities is omitted.

The stage control section 420 makes a decision as to whether there is an instruction to tilt the sample support base 16 (step S400).

If the decision at step S400 is Yes, indicating that there is an instruction for tilting, the stage control section 420 causes the tilt drive mechanism 11 to perform a tilting operation for tilting the sample support base 16 (step S402).

Then, the drift reduction section 422 obtains information about the position of the center of gravity G of the unitary combination of the sample support base 16 and the sample S, the position being detected by the sensor 402 (step S404), and makes a decision as to whether the position of the center of gravity G lies on the axis of rotation R (step S406).

If the decision at step S406 is No, indicating that the position of the center of gravity G does not lie on the axis R, the drift reduction section 422 causes the rotary drive mechanism 15 to perform a drift reducing operation (step S408). The drift reduction section 422 sets the direction of rotation of the rotary stage 15a depending on the direction of tilt of the sample S and on the position of the center of gravity G, rotates the rotary stage 15a in the direction of rotation set into the rotary drive mechanism 15, and then executes the drift reducing operation in a reverse rotational direction.

The processing section 42 ends the processing sequence for tilting either after the rotary drive mechanism 15 has been caused to execute a drift reducing operation or if the decision at step S406 is Yes, indicating that the center of gravity G lies on the axis of rotation R.

### 4.4. Advantageous Effects

In the electron microscope 400, the tilt drive mechanism 11 tilts the sample support base 16 about the axis T, and the rotary drive mechanism 15 rotates the sample support base 16 about the axis R that is perpendicular to the axis of tilt T. The tilting operation is to tilt the sample support base 16 about the axis T. The drift reducing operation consists of rotating the sample support base 16 in a first direction of rotation and then rotating the base 16 in a second direction of rotation opposite to the first direction of rotation. Therefore, in the electron microscope 400, drift of the sample support base 16 around the axis R due to tilting of the base 16 can be reduced.

### 5. Fifth Embodiment

### 5.1. Electron Microscope

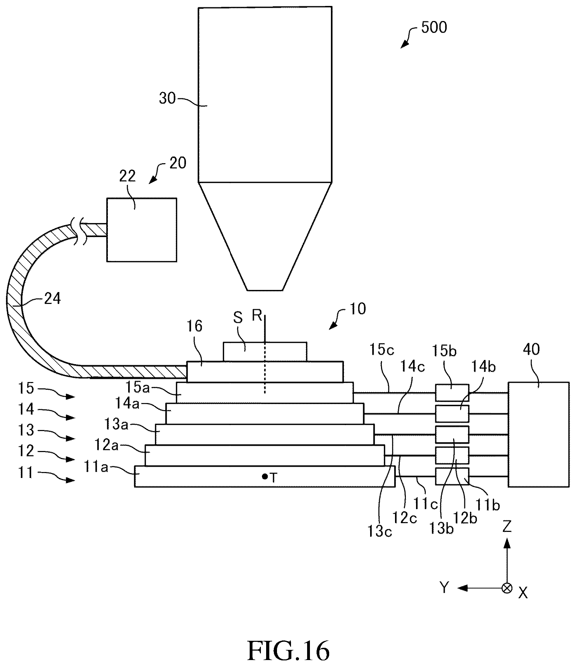

An electron microscope associated with a fifth embodiment is next described by referring to FIG. 16, which shows one example of the electron microscope, 500, associated with the fifth embodiment. Those members of the electron microscope 500 which are similar in function to their respective counterparts of the electron microscope 100 associated with the first embodiment are hereinafter indicated by the same reference numerals as in the foregoing figures and a detailed description thereof is omitted.

In the electron microscope 500, the position at which the heat transfer member 24 is connected to the sample support base 16 is different from that in the above-described electron microscope 100 of FIG. 1.

### 5.2. Operation

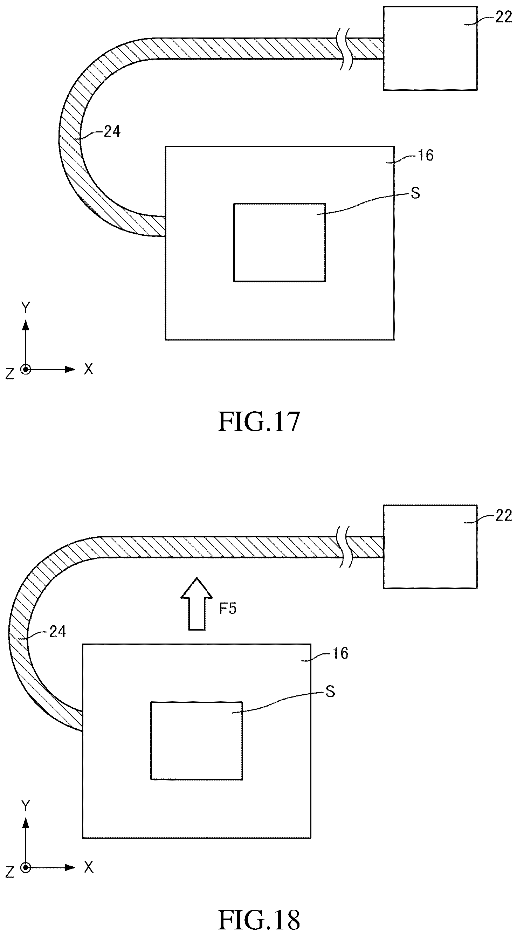

An operation of the electron microscope 500 for moving the sample support base 16 along the X axis is next described by referring to FIGS. 17 and 18, which illustrate the operation of the sample stage 10.

As shown in FIGS. 17 and 18, the sample support base 16 is moved in the -X direction. At this time, the X stage 13a is moved also in the -X direction. Consequently, the sample support base 16 moves from the initial position (x1, y1, z1, r1, t1) of FIG. 17 to a target position (x2, y1, z1, r1, t1) of FIG. 18.

If the sample support base 16 is moved in the -X direction from the initial position as shown in FIG. 18, the heat transfer member 24 deforms, applying a force F5 in the +Y direction to the sample support base 16. This causes the sample support base 16 to drift in the +Y direction due to (i) flexure of mechanical parts including a shaft, joints, and gears making up the Y force transfer member 14c, (ii) backlash between the mechanical parts, and/or stress (iii) caused by the viscous resistance of lubricant used for the mechanical parts concomitantly with the application of the force F5 in the +Y direction to the support base 16.

Therefore, where a moving operation for moving the sample support base 16 in the -X direction is performed, a drift reducing operation is performed to reduce drift of the sample support base 16 relative to the Y axis due to the moving operation. This can alleviate flexure of mechanical parts making up the Y force transfer member 14c in response to the force F5 applied to the sample support base 16 and stress caused by the viscous resistance of lubricant used for the mechanical parts. Furthermore, the posture of the heat transfer member 24 can be varied by the drift reducing operation, whereby the force F5 applied to the sample support base 16 by the heat transfer member 24 can be mitigated. In addition, drift of the sample support base 16 due to backlash between mechanical parts can be reduced by the drift reducing operation. Consequently, drift of the sample support base 16 in the +Y direction caused by movement of the base 16 in the -X direction can be reduced.

In particular, the Y stage 14a is first moved for a distance of Δy in the +Y direction. Thus, the sample support base 16 moves from the target position (x2, y1, z1, r1, t1) of FIG. 18 to the swing-back position (x2, yA, z1, r1, t1).

Then, the Y stage 14a is moved for a distance of Δy in the +Y direction.
Consequently, the sample support base 16 returns from the swing-back position (x2, yA, z1, r1, t1) to the target position (x2, y1, z1, r1, t1) of FIG. 18. As a result, drift of the sample support base 16 in the +Y direction can be reduced.

### 5.3. Processing Sequence

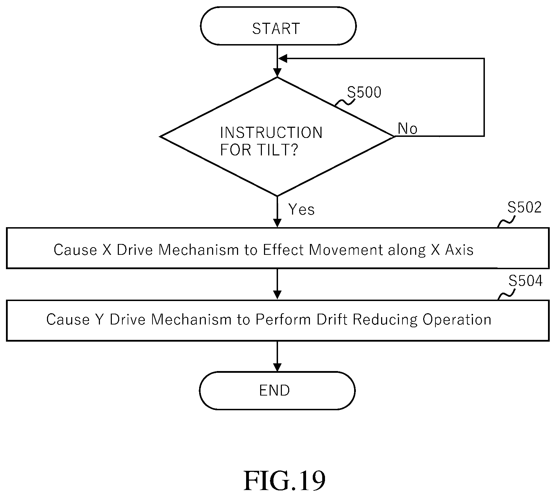

The processing sequence of the controller 40 when the sample support base 16 is moved in the -X direction is next described by referring to the flowchart of FIG. 19, which illustrates one example of the processing sequence of the controller 40 for movement along the X axis.

The stage control section 420 makes a decision as to whether or not there is an instruction to move the sample support base 16 in the -X direction (step S500). The instruction for the movement includes information about the direction and amount of the movement of the sample support base 16.

If the decision at step S500 is Yes, indicating that there is an instruction for movement, the stage control section 420 causes the X drive mechanism 13 to move the sample support base 16 in the -X direction (step S502). In particular, the stage control section 420 instructs the X force generator 13b to move the X stage 13a for a designated distance in a designated direction.

Then, the drift reduction section 422 causes the Y drive mechanism 14 to perform a drift reducing operation (step S504). In particular, the drift reduction section 422 causes the Y force generator 14b to move the Y stage 14a for a distance of Δy in the +Y direction and then to move the Y stage 14a for a distance of Δy in the -Y direction. After the execution of the drift reducing operation, the controller 40 ends the processing sequence for movement along the X axis.

### 5.4. Advantageous Effects

The electron microscope 500 includes the heat transfer member 24 connected to the sample support base 16. When the sample support base 16 is moved in the -X direction, i.e., along the X axis, the heat transfer member 24 applies a force to the sample support base 16 in the +Y direction, i.e., along the Y axis, perpendicular to the X axis. The X drive mechanism 13 moves the sample support base 16 along the X axis. The Y drive mechanism 14 moves the sample support base 16 along the Y axis. A moving operation is to move the sample support base 16 in the -X direction. A drift reducing operation consists of moving the sample support base 16 in the +Y direction and then moving the base in a reverse direction, i.e., in the -Y direction. Therefore, in the electron microscope 500, drift of the sample support base 16 in the +Y direction due to the movement of the base 16 in the -X direction can be reduced.

### 5.5. Modifications

In the above-described fifth embodiment, drift of the sample support base 16 in the +Y direction due to movement of the base 16 in the -X direction is reduced. Drift caused by moving the sample support base 16 in other than the -X direction can be reduced in the same manner as in the fifth embodiment. For example, in the electron microscope whose sample support base 16 drifts in the +X direction when the sample support base 16 is moved in the -Y direction, if the sample support base 16 is moved in the -Y direction, a drift reducing operation consisting of moving the X stage 13a in the +X direction and then moving it in the -X direction may be performed.

### 6. Sixth Embodiment

An electron microscope associated with a sixth embodiment is next described. In the following, only differences with the above-described electron microscopes 100, 200, 300, 400, and 500 are described. A description of similarities is omitted.

An electron microscope associated with a sixth embodiment has the configuration of the electron microscope 100 of FIG. 1, the configuration of the electron microscope 200 of FIG. 7, the configuration of the electron microscope 300 of FIG. 10, the configuration of the electron microscope 400 of FIG. 13, and the configuration of the electron microscope 500 of FIG. 16. That is, the electron microscope associated with the sixth embodiment can function as the electron microscopes 100, 200, 300, 400, and 500.

In the electron microscope associated with the sixth embodiment, the processing section 42 displays a GUI (graphical user interface) screen on the display section 46 for selection of the functions of the five electron microscopes. Control programs for causing the present electron microscope to function as the above-described five electron microscopes are stored in the storage section 48. If an electron microscope function is selected in the GUI screen, the processing section 42 carries out the control program corresponding to the selected function.

If the user selects the functions of the electron microscope 100 in the GUI screen, for example, the processing section 42 executes a control program for realizing the functions of the selected electron microscope 100. Consequently, the electron microscope associated with the sixth embodiment functions as the electron microscope 100.

In the GUI screen, the functions of plural electron microscopes may be selected. For example, if the function of the electron microscope 100 and the function of the electron microscope 500 are selected, the electron microscope associated with the sixth embodiment functions as the electron microscope 100 and as the electron microscope 500. In this case, if a tilting operation for tilting the sample support base 16 is performed, or if an operation for moving the sample support base 16 in the -X direction is performed, a drift reduction operation for reducing drift relative to the Y axis is performed.

### 7. Modifications

It is to be understood that the present invention is not restricted to the foregoing embodiments but rather can be implemented in variously modified forms without departing from the gist of the present invention.

### 7.1. First Modification

In the above-described first embodiment, when the sample support base 16 is tilted counterclockwise by Δt, an operation for reducing drift occurring along the Y axis is performed. In addition, an operation for reducing drift occurring in the direction of tilt may be performed.

If the tilt stage 11a is tilted counterclockwise in order to tilt the sample support base 16 counterclockwise, drift occurs in the sample support base 16, which would tilt the base 16 counterclockwise because of (i) flexure of mechanical parts making up the tilting force transfer member 11c, (ii) backlash between the mechanical parts, and/or (iii) stress caused by the viscous resistance of the lubricant used for the mechanical parts concomitantly with tilting of the tilt stage 11a.

As an operation for reducing drift of the sample support base 16 due to counterclockwise tilting of the base 16, the tilt stage 11a is tilted counterclockwise from the target position and then tilted clockwise back to the target position. Consequently, drift of the sample support base 16 in the direction of tilt can be reduced.

A similar operation can be performed for the second to fourth embodiments described above. In the fifth embodiment described above, if the sample support base 16 is moved in the -X direction, an operation for reducing drift of the sample support base 16 in the +Y direction is performed. In addition, an operation for reducing drift of the sample support base 16 in the -X direction may be effected and consists of moving the X stage 13a in the -X direction from the target position and then moving the X stage 13a in the +X direction back to the target position.

### 7.2. Second Modification

In the above-described first embodiment, after the tilt drive mechanism 11 performs a tilting operation, the Y drive mechanism 14 performs a drift reducing operation. That is, the tilt drive mechanism 11 performs a tilting operation to move the sample support base 16 from the initial position (x1, y1, z1, r1, t1) to the target position (x1, y1, z1, r1, t2). Then, the Y drive mechanism 14 performs a tilting operation to move the sample support base 16 from the target position (x1, y1, z1, r1, t2) to the swing-back position (x1, yA, z1, r1, t2) and thence back to the target position (x1, y1, z1, r1, t2).

In contrast, in the first embodiment, the Y drive mechanism 14 may perform a drift reducing operation while the tilt drive mechanism 11 is performing a tilting operation. For example, where the sample support base 16 is tilted counterclockwise by Δt, the tilt drive mechanism 11 first tilts the tilt stage 11a counterclockwise by Δt' (t' < t). Consequently, the sample support base 16 moves from the initial position (x1, y1, z1, r1, t1) to a halfway position (x1, y1, z1, r1, t2').

When the sample support base 16 is located at the halfway position (x1, y1, z1, r1, t2'), the Y drive mechanism 14 performs a drift reducing operation. Consequently, the sample support base 16 moves from the halfway position (x1, y1, z1, r1, t2') to the swing-back position (x1, yA, z1, r1, t2') and thence back into the halfway position (x1, y1, z1, r1, t2').

Then, the tilt drive mechanism 11 tilts the tilt stage 11a counterclockwise by Δt - t'. Consequently, the sample support base 16 moves from the halfway position (x1, y1, z1, r1, t2') to the target position (x1, y1, z1, r1, t2).

Also, in the second to fifth embodiments, a drift reducing operation may be performed while a tilting operation for moving the sample support base 16 from the initial position to the target position is being carried out, in the same manner as in the first embodiment.

### 7.3. Third Modification

In the above-described first to sixth embodiments, the observation instrument associated with the present invention is a scanning electron microscope for observing the sample S using electrons. The observation instrument associated with the present invention may also be instruments for observing samples using a beam of charged particles (such as electrons or ions), radiations (such as X-rays), or light (such as laser light). Examples of such an observation instrument include electron probe microanalyzer (EPMA), Auger microprobe, electron beam lithography system, electron beam 3D printer, ion beam milling apparatus (such as focused ion beam (FIB) system and Cross-Section Polisher (trademark registered)), X-ray photoelectron spectrometer (XPS), X-ray fluorescence (XRF) analyzer, optical microscope, laser microscope, and laser beam machine.

The above-described embodiments and modifications are merely exemplary and the present invention is not restricted thereto. For example, the embodiments and modifications can be combined appropriately.

The present invention is not restricted to the foregoing embodiments but rather implemented in variously modified forms. For example, the present invention embraces configurations (e.g., configurations identical in function and method) which are substantially identical to the configurations described in the above embodiments. Furthermore, the invention embraces configurations which are similar to the configurations described in the above embodiments except that their nonessential portions have been replaced. Further, the invention embraces configurations which are similar to the configurations described in any one of the above embodiments except that a well-known technique is added.

## Claims

1. An observation instrument for observing a sample, comprising:
a sample stage having a sample support base on which the sample is placed, a first drive mechanism for displacing the sample support base relative to a first axis, and a second drive mechanism for displacing the sample support base relative to a second axis different from the first axis; and
a controller for controlling the sample stage;
wherein, when the first drive mechanism is caused to perform a first operation for displacing the sample support base relative to the first axis, the controller causes the second drive mechanism to perform a second operation for reducing drift of the sample support base relative to the second axis due to the first operation.

2. An observation instrument as set forth in claim 1,
wherein said first drive mechanism tilts said sample support base relative to said first axis, while said second drive mechanism moves the sample support base along said second axis perpendicular to the first axis; and
wherein said first operation is to tilt the sample support base relative to the first axis serving as an axis of tilt, while said second operation consists of moving the sample support base in a first direction along the second axis and then moving the sample support base in a second direction opposite to the first direction.

3. An observation instrument as set forth in claim 2, wherein said first operation consists of tilting said sample support base about said first axis by a given angle or more.

4. An observation instrument as set forth in claim 2 or 3, further comprising a measuring device for measuring a weight of said sample placed on said sample support base, and wherein when the weight of the sample measured by the measuring device is greater than a threshold value, said controller operates to carry out said second operation.

5. An observation instrument as set forth in any one of claims 2 to 4, wherein said controller obtains information about the type of said sample support base, identifies the type, and makes a decision as to whether or not the controller operates to carry out said second operation according to the identified type of the sample support base.

6. An observation instrument as set forth in claim 1, wherein
said first drive mechanism tilts said sample support base about said first axis,
said second drive mechanism rotates the sample support base about said second axis perpendicular to the first axis,
said first operation consists of tilting the sample support base about the first axis, and
said second operation consists of rotating the sample support base in a first direction of rotation and then rotating the sample support base in a second direction of rotation opposite to the first direction of rotation.

7. An observation instrument as set forth in claim 1, wherein
there is further provided a mechanical member connected to said sample support base,
when the sample support base is moved in a first direction along said first axis, the member applies a force to the sample support base in a second direction along said second axis perpendicular to the first axis,
said first drive mechanism moves the sample support base along the first axis,
said second drive mechanism moves the sample support base along the second axis,
said first operation consists of moving the sample support base in the first direction, and
said second operation consists of moving the sample support base in the second direction and then moving the sample support base in a third direction opposite to the second direction.

8. An observation instrument as set forth in any one of claims 1 to 7, wherein said controller causes said second drive mechanism to perform said second operation after said first drive mechanism performs said first operation.

9. An observation instrument as set forth in any one of claims 1 to 7, wherein said controller causes said second drive mechanism to perform said second operation while said first drive mechanism is performing said first operation.

10. An observation instrument as set forth in any one of claims 1 to 9, further comprising an optical system for illuminating said sample with a beam of charged particles.

11. A method of controlling a sample stage for use in an observation instrument, the sample stage comprising: a sample support base on which a sample is placed; a first drive mechanism for displacing the sample support base relative to a first axis; and a second drive mechanism for displacing the sample support base relative to a second axis different from the first axis, said method comprising the steps of:
causing the first drive mechanism to perform a first operation for displacing the sample support base relative to the first axis; and
causing the second drive mechanism to perform a second operation for reducing drift of the sample support base relative to the second axis due to the first operation if the first drive mechanism has been caused to perform the first operation for displacing the sample support base relative to the first axis.
